# EUROPEAN PATENT SPECIFICATION

(11) **EP 2 771 920 B1**
(45) Date of publication and mention of the grant of the patent: **24.08.2016**
(21) Application number: 12772194.2
(22) Date of filing: 10.10.2012
(51) Int. Cl.: H01L 51/52, H01L 51/00, H01L 51/44, H01L 21/288

(54) **SOLUTION-PROCESSABLE TUNGSTEN OXIDE BUFFER LAYERS AND ORGANIC ELECTRONICS COMPRISING SAME**
IN LÖSUNG VERARBEITBARE WOLFRAMOXID-PUFFERSCHICHTEN UND ORGANISCHE ELEKTRONIK, DIE DIESE UMFASST
COUCHES DE TAMPON D'OXYDE DE TUNGSTÈNE POUVANT ÊTRE TRAITÉES PAR DES SOLUTIONS ET DISPOSITIFS ÉLECTRONIQUES ORGANIQUES LES COMPORTANT

(30) Priority: 28.10.2011 EP 11008644
(43) Date of publication of application: 03.09.2014
(73) Proprietor: nanograde AG, 8712 Stäfa (CH)
(72) Inventor: LÜCHINGER, Norman, Albert, 8706 Meilen (CH); HALIM, Samuel, Claude, CH-8049 Zürich (CH)
(74) Representative: Grimm, Siegfried
(86) International application number: PCT/CH2012/000234
(87) International publication number: WO 2013/059948

(56) References cited:
- EP-A1- 0 678 563
- EP-A1- 1 618 953
- EP-A1- 1 847 575
- ANN-CHRISTIN DIPPEL ET AL: "Tungsten coatings by chemical solution deposition for ceramic electrodes in fluorescent tubes", JOURNAL OF MATERIALS CHEMISTRY, vol. 18, no. 29, 1 January 2008 (2008-01-01), page 3501, XP055020278, ISSN: 0959-9428, DOI: 10.1039/b802686f

## Description

The present invention relates to the field of organic electronics, such as OLEDs and OPVs. It particularly provides intermediates and materials suitable for manufacturing such organic electronics, to specific manufacturing methods and to specific uses.

It is known to use buffer layers in organic electronics, such as organic light emitting diodes (OLED) or organic photovoltaic cells (OPV), in order to increase device efficiency. These layers typically have a thickness below 100nm to retain optical transparency and a low serial resistance. Such layers may comprise WO₃ and/or MoO₃, which exhibit remarkably deep lying electronic states and are strongly n-doped by oxygen vacancies. Meyer et al. (Adv. Mater. 2008, 20, 3839-3843) disclose efficient hole-injection into organic materials with deep-lying HOMO levels from an ITO electrode covered with a MoO₃ or WO₃ hole injection layers. Simplified device structures consisting only of one or two organic layers can therefore be realized. M0O₃ and WO₃ hole injection layers mentioned above are typically manufactured by thermal evaporation under high vacuum; which is disadvantageous in terms of low-cost, large-area manufacturing processing.

Meyer et al. (Adv. Mater., Ger. 23, 70 2011) and Stubhan et al. (Appl. Phys. Lett. 98, 253308 2011) disclose suspensions comprising coated MoO₃ nanoparticles useful for the solution processing of MoO₃ HIL layers in organic electronics. Both documents are silent about the coating type. However, the processes disclosed therein are considered disadvantageous. First, as the solvent (xylene) damages the active organic layer in OLEDs or OPVs. Therefore, application of the current dispersion is limited to inorganic functional layers. Second, as a polymeric dispersing agent is used for the particle stabilization. Upon application of the dispersion and drying-off the xylene, the dispersing agent remains in deposited MoO₃ layers. This non-volatile organic material has a negative impact on the electronic properties of the HIL layer because all the inorganic HIL nanoparticles are covered with an electrically insulating organic shell. Therefore, an additional cleaning treatment by temperature annealing or a plasma treatment is required which can damage organic functional layers.

Nakano et al (US2011212832) describe water based WO₃ dispersions. Due to the fact that WO₃ exhibits an isoelectric point at about pH 1, the WO₃ particles are negatively charged at pH 7 in water resulting in electrostatic particle stabilization. However, such dispersions are of limited use, as they cannot be applied on hydrophobic substrates, particularly due to the bad wettability of aqueous systems on such substrates. Further, Nakano et al. discuss addition of ethanol (up to 20 wt%) but find this embodiment disadvantageous due to aggregation and stability problems.

Kamikoriyama et al (EP1847575) describe conductive inks comprising metal powders and a dispersing medium, said dispersion medium comprising water, alcohols and metal salts.

Thus, it is an object of the present invention to mitigate at least some of these drawbacks of the state of the art. In particular, it is an aim of the present invention to provide compositions suitable for thin film formation on a plurality of substrates. It is a further aim to provide manufacturing methods for thin films avoiding vapor phase processes.

These objectives are achieved by a composition as defined in claim 1 and a method of claim 8. Further aspects of the invention are disclosed in the specification and independent claims, preferred embodiments are disclosed in the specification and the dependent claims.

The present invention will be described in detail below.

Unless otherwise stated, the following **definitions** shall apply in this specification:
The terms "a" "an," "the" and similar terms used in the context of the present invention are to be construed to cover both the singular and plural unless otherwise indicated herein or clearly contradicted by the context. Further, the terms "including", "containing" and "comprising" are used herein in their open, non-limiting sense. The term "containing" shall include both, "comprising" and "consisting of".

It is understood that the various embodiments, preferences and ranges as provided / disclosed in this specification may be combined at will. Further, depending of the specific embodiment, selected definitions, embodiments or ranges may not apply.

Percentages are given as weight-%, unless otherwise indicated herein or clearly contradicted by the context.

The present invention will be better understood by reference to the **figures**.

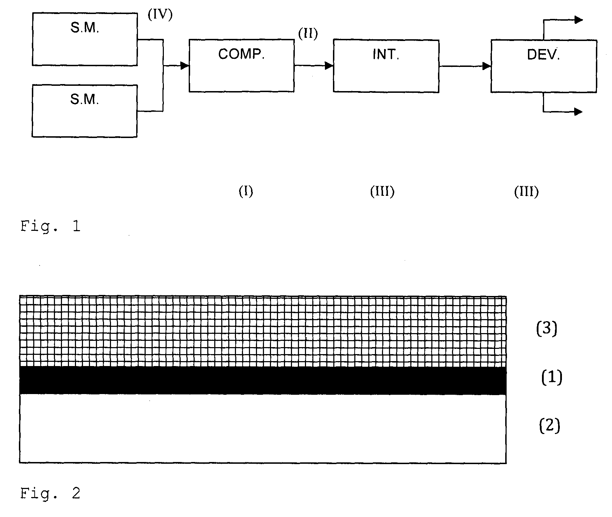

Fig. 1 shows a schematic set-up of the invention. In summary, the invention describes specific compositions containing WO₃ (COMP, 1^{st} aspect of the invention) which enable the solution deposition of WO₃ nanoparticle layers on hydrophobic substrates (INT, 2^{nd} aspect of the invention). The obtained thin films show a low residual organic content after drying under moderate conditions (3^{rd} aspect). These layers are useful in the manufacturing of organic electronics (DEV). The above compositions are obtainable as described in the 4^{th} aspect of the invention by the use of known starting materials (S.M.)
Fig. 2 shows the essential layers of an intermediate product (INT), useful for the manufacturing of organic electronics, wherein (1) is the tungsten oxide hole transport layer, (2) is an organic active layer and (3) is an electrode. The electrode can be transparent or non-transparent. Typically, the three depicted layers are only part of a more complex layer architecture forming an intermediate product; underneath or on top of the depicted layers can be different layers, such as a supporting substrate, and/or an electron transport layer and/or a second electrode.

In more general terms, in a **first aspect,** the invention relates to a composition in the form of a suspension, said composition containing (a) nanoparticles, selected from the group consisting of tungsten oxide and doped tungsten oxide, and (b) a homogeneous solvent composition. Said homogeneous solvent composition contains, preferably consists of, (i) water, (ii) a low boiling alcohol; (iii) a high boiling alcohol, whereby the amount of water (i) in said composition is below 20 wt% and whereby the amount of alcohols (ii) + (iii) in said composition is above 80 wt%. These compositions have beneficial properties and have advantageous uses as outlined below. It was found that the inventive compositions (i) show good wettability on hydrophobic substrates, such as organic functional layers; (ii) are compatible with organic materials, particularly no swelling or dissolution of organic materials is observed; (iii) show a high shelf-life. This aspect of the invention shall be explained in further detail:
The term **suspension** is known and relates to a heterogeneous fluid of an internal phase (i.p.) that is a solid and an external phase (e.p.) that is a liquid. In the context of the present invention, a suspension has a kinetic stability of at least 1 day (measured according to complete particle sedimentation). In an advantageous embodiment, the invention provides for a composition with (hydrodynamic size D₉₀ of less than 100 nm) a shelf-life of more than 7 days, particularly more than 2 months.
The term **nanoparticle** is known and particularly relates to solid particles having a particle size in the nanometer range.

In an advantageous embodiment, the nanoparticles have a mean primary particle size of 2 - 60 nm, preferably 5 - 30 nm (measured by transmission electron microscopy).

In a further advantageous embodiment, the nanoparticles in suspension have a hydrodynamic size D₉₀ of less than 100 nm (measured by dynamic light scattering or centrifugal sedimentation techniques)

In a further advantageous embodiment, the nanoparticles are synthesized by a gas phase process, preferably flame spray synthesis. Without being bound to theory, it is believed that the microstructure of such nanoparticles differs from the microstructure of particles synthesized e.g. by precipitation processes or by sublimation processes. Compositions as described herein and comprising particles made by gas phase processes are particularly stable and suitable in the applications described below.

The amount of nanoparticles in the inventive composition may - depending on the intended use - vary over a broad range, but typically is in the range of 0.1 - 10 wt%, preferably 1 - 5 wt% of the composition. In order to deposit WO₃ nanoparticle films with a dry thickness below 100nm by large-scale processes (such as roll-to-roll coating, spraying or doctor-blading), the WO₃ solid content of the corresponding composition should be comparatively low. Without being bound to theory, this is due to the fact that the application of the liquid dispersion results in a minimal wet film thickness which is difficult to minimize further. By reducing the amount of nanoparticles in the composition, the final nanoparticulate film thickness can be reduced to small values well below 100 nm.

The term **water** is known and particularly relates to purified water, such as de-ionized or distilled water. The amount of water in the inventive composition may - depending on the intended use - vary over a broad range, but typically is in the range of 0.1 - 18 wt%, especially 0.5 - 10 wt% of the composition. It was surprisingly found that this low amount of water is sufficient for stabilizing the nanoparticles.

The term **low boiling alcohol** is known and relates to alcohols having a boiling point of 65 - 97°C. It particularly relates to C1-C3 mono-alcohols; such as methanol, ethanol, propanol and isopropanol.
The amount of low boiling alcohol in the inventive composition may - depending on the intended use - vary over a broad range, but typically is in the range of 30 - 98 wt%, especially 40 - 97 wt% of the composition.

The term **high boiling alcohol** is known and relates to alcohols having a boiling point between 100 - 200°C, preferably 110-170°C. It particularly relates to C4-C9 mono-alcohols and C3-C7 alkoxy-alcohols.
Alkoxy-alcohols within the scope of the invention have a formula 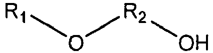 where R1 and R2 represent a linear or branched alkyl chain having 1 to 6 carbon atoms each and where the total number of carbon atoms is between 3 and 7; such as methoxy-ethanol, propoxy-ethanol, butoxy-ethanol, isopropoxy-ethanol, methoxy-propanol, ethoxy-butanol, propoxy-butanol.

The amount of high boiling alcohol in the inventive composition may - depending on the intended use - vary over a broad range, but typically is in the range of 1 - 50 wt%, especially 3 - 30 wt% of the composition.

In an advantageous embodiment, the invention provides a composition as described herein which is free of, or essentially free of, surfactants.

In an advantageous embodiment, the suspension of the present invention is free of, or essentially free of, dispersing agents.

In an advantageous embodiment, the invention provides a composition as described herein which has a residual organic carbon content of less than 2.5 wt%, particularly less than 1 wt%, this value being obtained after drying for 1h at 150°C.

In an advantageous embodiment, the invention provides a composition as described herein wherein said nanoparticles consist of tungsten oxide having the chemical composition WO₃ ("pure tungsten oxide").

In an advantageous embodiment, the invention provides a composition as described herein wherein said nanoparticles consist of tungsten oxide wherein 1 - 40 wt%, preferably 1 - 20 wt%, of said WO₃ are replaced by one or more transition metals. ("doped tungsten oxide). In a preferred embodiment, said transition metals are selected from the group consisting of Mo, Ni and V. In a particularly preferred embodiment, the doped tungsten oxide comprises 2 - 30 wt% Molybdenum.

The invention further provides for various uses of the inventive composition. These include: (a) the use of tungsten oxide nanoparticle films as a hole transport layer in organic solar cells or in organic light emitting diodes or in organic photo detectors; (b) the use of tungsten oxide nanoparticle films in photochromic applications; (c) the use tungsten oxide nanoparticle films as a catalytic active material ("a catalyst").

In a **second aspect,** the invention relates to a process for manufacturing thin films of nanoparticles. These films have beneficial properties and have advantageous uses as outlined below. It was found that the inventive films (i) are obtainable by a solution process; (ii) are essentially free of (or free of) residual organic materials after drying at a temperature below 150°C; (iii) are thin (below 100 nm) (iv) have a low final surface roughness (below 100 nm). This aspect of the invention shall be explained in further detail below.

In one embodiment, the invention provides a method for manufacturing a thin film, comprising the steps of (a) applying a composition as described herein on a substrate or coated substrate and (b) removing the solvent from said composition.
Step a: Many processes are known to apply a liquid composition to a substrate; a person skilled in the art is in a position to appropriately select. Suitable are, for example roll-to-roll coating, sheet-to-sheet coating, spin-coating or doctor-blading. Such processes are generally considered advantageous for large scale production, when compared to vacuum-based processes.
Step b: Many processes are known to remove a liquid from a coated substrate; a person skilled in the art is in a position to appropriately select. Suitable are, for example drying at elevated temperature and ambient pressure. Drying may take place in air or in a protecting gas, such as nitrogen.

Advantageously, the invention relates to a method as described herein, wherein said film has a thickness between 5 - 100 nm, preferably 10 - 80 nm (determined by microscopy).

Advantageously, the invention relates to a method as described herein, wherein said film has a mean surface roughness below 100 nm, especially below 50 nm (determined by microscopy).

Advantageously, the substrate referred to above is a polymer substrate, preferably a polymer substrate with a surface free energy below 40 mJ/m², particularly preferably below 30 mJ/m². Such substrates may be uncoated or coated and include organic active layers (2) as defined above.

Depending on the composition used in step (a) and/or the removing step (b), these thin films are either known or novel.

Thus, the invention provides for an alternative manufacturing method of thin films, this method being advantageous over the known methods. For example, there is no need for a cleaning step of the as-deposited films (e.g. by plasma or ozone). Further, the thin film produced according to this embodiment, is defect-free, particularly when deposited on hydrophobic polymer substrates. Further, the thin film produced according to this embodiment, shows < 2.5 wt%, particularly < 1 wt%, organic residuals.

The invention also provides for new films, being subject of the present invention. Such new thin films are applied on a polymer substrate or a coated polymer substrate and are further characterized by one or more of the following parameters
(i) being essentially free of (or free of) residual organic materials after drying at a temperature below 150°C; (ii) having a thickness below 100 nm (iv) having a final surface roughness below 100 nm; and / or (iv) consist of nanoparticles obtained by a gas phase process.

The invention further provides for a process of manufacturing organic electronics and electrical intermediates (both as defined herein), said process comprising the steps of providing a substrate; performing steps (a) and (b) (as defined above); and optionally performing further coating steps. Due to the beneficial properties of the thin film (as defined herein), there is no need of performing a cleaning step after step (b). Thus, the invention also provides for a process of manufacturing organic electronics and electrical intermediates, said process comprising the steps of providing a substrate; performing steps (a) and (b) ; and optionally performing further coating steps, wherein no cleaning step takes place after step (b).

In a **third aspect,** the invention relates to an electrical element (intermediate), comprising a thin film on a polymer substrate or a coated polymer substrate as described herein or obtained by a method as described herein, and to a device comprising one or more of such elements. This aspect of the invention shall be explained in further detail below.

The terms organic electronics, OLED, OPV are known in the field and relate to electronic devices comprising a substrate and a multitude of layers, wherein at least one layer is a hole transport layer (HTL). Depending on the remaining layers, its structure and connection, these devices serve a multitude of purposes, such as an OLED, an OPV, an organic photodetector or a tandem solar cell.

In one embodiment, the invention relates to a device comprising one or more electrical elements as described herein, preferably selected from the group of organic electronics, particularly an organic solar cell (OPV), an organic light emitting diode (OLED), an organic photodetector or a tandem solar cell.

In one embodiment, the invention relates to an OLED wherein the HTL (i) is obtained by a method as described herein or (ii) consists of a thin layer as described herein. In this embodiment, the OLED preferably comprises a substrate selected from the group of organic polymers.

In a further embodiment, the invention relates to an OPV wherein the HTL (i) is obtained by a method as described herein or (ii) consists of a thin layer as described herein. In this embodiment, the OPV preferably comprises a substrate selected from the group of organic polymers.

In a further embodiment, the invention relates to an OPV or OLED device with ordinary architecture where the hole transport layer is applied between the front electrode and the organic layer.

In a further embodiment, the invention relates to an OPV or OLED device with inverted architecture where the hole transport layer is applied between the back electrode and the organic layer.

In a further embodiment, the invention relates to an OPV device with tandem architecture.

In a **fourth aspect,** the invention relates to a method for manufacturing a composition as described herein. This aspect shall be explained in further detail below.

In one embodiment, the invention relates to a method for manufacturing a composition as described herein (c.f. fig.1), comprising the steps of (a) providing a homogeneous solvent composition (S.M), (b) providing nanoparticles (S.M)(c) combining said nanoparticles with said homogeneous solvent composition to obtain a suspension (COMP.).

To further illustrate the invention, the following **examples** are provided. These examples are provided with no intent to limit the scope of the invention.

**Starting Materials:** WO₃ nanoparticles were synthesized by flame spray synthesis. For the preparation of the precursor, 42g of sodium metatungstate (Fluka) was dissolved in 750g distilled water and 75g acetic acid. After adding 225g aniline the solution was manually shaken for 3 min and washed twice with water in order to remove sodium and acetic acid. The obtained solution was diluted with THF 1:2 by weight. The precursor then was fed (5 ml min⁻¹, HNP Mikrosysteme, micro annular gear pump mzr-2900) to a spray nozzle, dispersed by oxygen (7 1 min⁻¹, PanGas tech.) and ignited by a premixed methane-oxygen flame (CH₄: 1.2 1 min⁻¹, O₂: 2.2 1 min⁻¹) . The off-gas was filtered through a glass fiber filter (Schleicher&Schuell) by a vacuum pump (Busch, Seco SV1040CV) at about 20 m³ h⁻¹. The obtained blue WO₃ nanopowder was collected from the glass fiber filter.
**Example 1:** For the preparation of the WO₃ suspension 4 wt% of WO₃ nanopowder was dispersed in a mixture of 10 wt% distilled water, 90 wt% dry ethanol and 5 wt% butoxyethanol. The finally prepared dispersion is transparent and stable for more than 3 months.
Drying of the obtained dispersion at about 150°C resulted in a residual carbon content (microanalysis) of below 2 wt%. WO₃ nanoparticle films were spin-coated on HDPE and PVC foils resulting in highly transparent WO₃ films. The thickness of the deposited WO₃ films was determined as ~50nm by scanning electron microscopy (SEM). The surface roughness was estimated to be in the range of 20nm (SEM).
**Example 2:** An electrostatically stabilized WO₃ suspension was obtained by using 85 wt% ethanol, 5 wt% of propoxyethanol, 4 wt% of WO₃ (as described above) and 6 wt% of water without the use of an organic surfactant or dispersing agent.
After dispersion application the coated material is dried at approx. 150 °C. During drying, the ethanol evaporates first, leaving back water, WO₃ and propoxyethanol. (It is believed propoxyethanol prevents de-wetting of the still wet film composed of water and WO₃.)
Next, water evaporates prior leaving a wet film of WO₃ and propoxyethanol only. WO₃ and propoxyethanol is not a stable dispersion system, but the film drying at this stage is almost complete and WO₃ has no time to form loose agglomerates. As a result, a thin film with a thickness below 100 nm and a surface roughness below 100 nm is obtained, free of residual organic materials.
**Examples 3-15:** According to ex. 1, the following examples are prepared using the respective starting materials, whereby examples 3 - 7 are for comparative purposes.

| Ex. | WO₃ (wt%) | H₂O (wt%) | low boiling alcohol (wt%) | high boiling alcohol (wt%) | Suspension stability (#) | Wettability (##) |
|---|---|---|---|---|---|---|
| 3* | 5% | 0% | 95% ethanol | 0% | very low | n.a. |
| 4* | 3% | 6% | 0% | 91% isopropoxy ethanol | low | n.a. |
| 5* | 4% | 6% | 90% ethanol | 0% | high | no |
| 6* | 2% | 3% | 95% isopropanol | 0% | medium | no |
| 7* | 2.5% | 25% | 22.5% methanol | 50% butoxyethanol | high | no |
| 8 | 4% | 6% | 70% ethanol | 20% 1-ethoxy-2-propanol | high | yes |
| 9 | 2% | 3% | 50% ethanol | 45% 1-methoxy-2-propanol | low | medium |
| 10 | 2% | 3% | 50% ethanol | 45% methoxy-ethanol | low | yes |
| 11 | 4% | 6% | 75% ethanol | 15% propoxy-ethanol | high | yes |
| 12 | 4% | 6% | 85% | 5% | high | yes |
| | | | methanol | butoxy-ethanol | | |
| 13 | 4% | 6% | 80% ethanol | 10% 1-butanol | high | yes |
| 14 | 8% | 12% | 50% ethanol | 30% isopropoxy-ethanol | high | yes |
| 15 | 1% | 4% | 90% isopropanol | 5% isopropoxy-ethanol | high | yes |

| | | | | | | |
|---|---|---|---|---|---|---|
| (#): Suspension stability is measured at ambient conditions, whereby: *very low* = stability below 10 hrs; *low* = stability below 2 days; *medium* = stability below 7 days; *high* = stability more than 7 days; (##): Wettability is measured at ambient conditions on HDPE foils, whereby: *no* = de-wetting; *medium* = film formation with small defects; *yes* = film formation without defects. Examples 1, 8, 10 - 15 also show good wettability on PVC foils. Thus, the inventive suspensions show good wettability on hydrophobic substrates. | | | | | | |

It was also observed that none of the suspensions according to ex. 1 - 15 damages PVC or HDPE foils. Thus, the solvent combination used in the inventive suspensions, does not damage organic electronic substrates.
**Example 16:** [Further processing of the thin films] The films obtained according to ex. 8, 10 - 15 are dried in Air (150°C). The thus obtained films have a thickness below 100 nm, are defect free and a surface roughness below 100 nm (all as determined by microscopy).
Further, the thus obtained films have less than 2.5 wt% organic residuals within the film. For these dried films, further processing is possible without further purification. Thus, no cleaning step - such as plasma or ozone treatment - of the as-deposited films is required.

## Claims

1. A composition in the form of a suspension, said composition containing
a. Nanoparticles, selected from the group consisting of tungsten oxide and doped tungsten oxide,
b. a homogeneous solvent composition consisting of
(i) water,
(ii) a low boiling alcohol selected from the group consisting of methanol, ethanol, propanol, and isopropanol;
(iii)a high boiling alcohol, selected from the group of C4-C9 alcohols and C3-C7 alkoxyalcohols;
whereby the amount of water (i) in said composition is below 20 wt% and
whereby the amount of alcohols (ii)+(iii) is above 80 wt%.

2. The composition of claim 1 containing of
a. 0.1 - 10 wt% of said nanoparticles;
b. a homogeneous solvent composition consisting of
(i) 0.1 - 18 wt% of water
(ii) 30 - 98 wt% low boiling alcohol
(iii) 1 - 50 wt% high boiling alcohol.

3. The composition of any of the preceding claims
a. which is free of surfactants or dispersing agents and / or
b. which has a residual organic carbon content of less than 2.5 wt% (after drying for 1h at 150°C).

4. The composition of any of the preceding claims
wherein said nanoparticles
a. consist of tungsten oxide having the chemical composition WO₃ or
b. consist of doped tungsten oxide wherein 1-40 wt% (based on WO₃) of said WO₃ are replaced one or more transition metals.

5. The composition of any of the preceding claims
wherein said nanoparticles
a. have a mean primary particle size of 2 - 60 nm and / or
b. have a hydrodynamic size D₉₀ in suspension of less than 100 nm.

6. The composition of any of the preceding claims
wherein said nanoparticles are synthesized by a gas phase process.

7. The composition of any of the preceding claims
wherein said high boiling alcohol
a. has a boiling point below 200°C and / or
b. has a formula 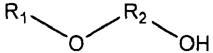 where R1 and R2 represent a linear or branched alkyl chain having 1 to 6 carbon atoms each and where the total number of carbon atoms is between 3 and 7.

8. A method for manufacturing a thin film, comprising the steps of
a. applying a composition according to any of the preceding claims on a substrate or coated substrate and
b. removing the solvent from said composition.

9. The method of claim 8
a. wherein the composition of step (a) is applied by roll-to-roll coating, sheet-to-sheet coating, spin-coating or doctor-blading and / or
b. wherein the solvent of step (b) is removed at elevated temperature.

10. The method of claim 8 or 9, wherein said film
a. has a thickness between 5 - 100 nm, and / or
b. has a mean surface roughness below 100 nm.

11. The method according to any of claims 8 - 10, wherein said substrate is a polymer substrate, preferably a polymer substrate with a surface free energy below 40 mJ/m2.

12. A thin film, obtained bv a method according to claim 11.

13. An electrical element, comprising a thin film obtained by a method according to claim 11.

14. A device comprising one or more electrical elements according to claim 13, preferably selected from the group of organic electronics, particularly an organic solar cell (OPV), an organic light emitting diode (OLED) or an organic photo detector.

15. A method for manufacturing a composition according to any of claims 1 - 7, comprising the steps of
a. providing a homogeneous solvent composition
b. providing nanoparticles
c. combining said nanoparticles with said homogeneous solvent composition to obtain a suspension.

16. Use of a suspension of a composition according to any of claims 1 - 7 for manufacturing a thin film
a. suitable as a hole transport layer in organic solar cells, in organic light emitting diodes or in organic photo detectors;
b. in photochromic applications; and / or
c. as a catalyst.

## Patentansprüche

1. Eine Zusammensetzung in der Form einer Suspension, wobei die Zusammensetzung
a. Nanopartikeln, ausgewählt aus der Gruppe bestehend aus Wolframoxid und gedoptem Wolframoxid,
b. eine homogene Lösungsmittelzusammensetzung bestehend aus
(i) Wasser,
(ii) einem niedrigsiedenden Alkohol, ausgewählt aus der Gruppe bestehend aus Methanol, Ethanol, Propanol, und Isopropanol;
(iii) einem hochsiedenden Alkohol, ausgewählt aus der Gruppe bestehend aus C4-C9-Alkoholen und C3-C7-Alkoxylalkoholen;
enthält,
wobei der Wassergehalt (i) in der Zusammensetzung unter 20 Gew.% ist und
wobei der Alkoholgehalt (ii)+(iii) über 80 Gew.% ist.

2. Die Zusammensetzung nach Anspruch 1, enthaltend
a. 0.1 - 10 Gew.% der Nanopartikeln;
b. eine homogene Lösungsmittelzusammensetzung bestehend aus
(i) 0.1 - 18 Gew.% Wasser
(ii) 30 - 98 Gew.% niedrigsiedendem Alkohol
(iii) 1 - 50 Gew.% hochsiedendem Alkohol.

3. Die Zusammensetzung nach einem der vorangehenden Ansprüche
a. welche frei von Tensiden oder Dispergiermittel ist und/oder
b. welche einen Restgehalt von organischem Kohlenstoff von weniger als 2.5 Gew.% (nach Trocknung für 1 h bei 150°C) hat.

4. Die Zusammensetzung nach einem der vorangehenden Ansprüche wobei die Nanopartikel
a. aus Wolframoxid mit der chemischen Zusammensetzung WO₃ besteht oder
b. aus gedoptem Wolframoxid besteht, wobei 1-40 Gew.% (basierend auf WO₃) des WO₃ durch ein oder mehrere Übergangsmetalle ersetzt werden.

5. Die Zusammensetzung nach einem der vorangehenden Ansprüche wobei die Nanopartikel
a. eine Durchschnittsgrösse primärer Partikel von 2 - 60 nm haben und/oder
b. eine hydrodynamische Grösse D₉₀ in der Suspension von weniger als 100 nm haben.

6. Die Zusammensetzung nach einem der vorangehenden Ansprüche, wobei die Nanopartikel mittels eines Gasphasenprozesses synthetisiert werden.

7. Die Zusammensetzung nach einem der vorangehenden Ansprüche wobei der hochsiedende Alkohol
a. einen Siedepunkt unter 200°C hat und/oder
b. eine Formel 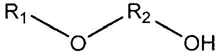 hat,
wobei R1 und R2 eine lineare oder verzweigte Alkylkette repräsentieren, die jeweils 1 bis 6 Kohlenstoffatomen besitzen und wobei die Gesamtanzahl der Kohlenstoffatome zwischen 3 und 7 ist.

8. Ein Verfahren zur Herstellung eines dünnen Films, umfassend die Schritte
a. Aufbringen einer Zusammensetzung nach einem der vorangehenden Ansprüche auf einem Substrat oder einem beschichteten Substrat und
b. Entfernen des Lösungsmittels von der Zusammensetzung.

9. Das Verfahren nach Anspruch 8
a. wobei die Zusammensetzung des Schritts (a) durch Rolle-zu-Rolle-Beschichtung, Sheet-to-Sheet-Beschichtung, Spin-Beschichtung oder Doctor-Blading und/oder
b. wobei das Lösungsmittel aus Schritt (b) bei erhöhter Temperatur entfernt wird.

10. Das Verfahren nach Anspruch 8 oder 9, wobei der Film
a. eine Dicke zwischen 5 - 100 nm, und/oder
b. eine durchschnittliche Oberflächenrauheit unter 100 nm hat.

11. Das Verfahren nach einem der Ansprüche 8 - 10, wobei das Substrat ein Polymersubstrat ist, bevorzugt ein Polymersubstrat mit einer Oberflächenenergie unter 40 mJ/m2.

12. Ein dünner Film, erhalten mittels eines Verfahrens nach Anspruch 11.

13. Ein elektrisches Element, umfassend einen dünnen Film erhalten mittels eines Verfahrens nach Anspruch 11.

14. Eine Vorrichtung umfassend ein oder mehrere elektrische Elemente nach Anspruch 13, bevorzugt ausgewählt aus der Gruppe der organischen Elektronik, insbesondere eine organische Solarzelle (OPV), eine organische Leuchtdiode (OLED) oder ein organischer Photodetektor.

15. Ein Verfahren zur Herstellung einer Zusammensetzung nach einem der Ansprüche 1 - 7, umfassend die Schritte
a. Bereitstellen einer homogenen Lösungsmittelzusammensetzung
b. Bereitstellen von Nanopartikeln
c. Kombinieren der Nanopartikel mit der homogenen Lösungsmittelzusammensetzung um eine Suspension zu erhalten.

16. Verwendung einer Suspension einer Zusammensetzung nach einem der Ansprüche 1 - 7 zur Herstellung eines dünnen Films
a. geeignet als lochleitende Schicht in organische Solarzellen, in organische Leuchtdioden oder in organische Photodetektoren;
b. in photochromen Anwendungen; und/oder
c. als Katalysator.

## Revendications

1. Une composition sous la forme d'une suspension, ladite composition contenant,
a. des nanoparticules sélectionnées du groupe consistant d'oxyde de tungstène et d'oxyde de tungstène dopé,
b. une composition de solvant homogène consistant
(i) d'eau,
(ii) d'un alcool à bas point d'ébullition sélectionné du groupe consistant de méthanol, éthanol, propanol, et isopropanol;
(iii) un alcool à haut point d'ébullition, sélectionné du groupe des alcools C4-C9 et des alcoxyalcools C3-C7;
la quantité d'eau (i) dans ladite composition étant inférieure à 20 % par poids et
la quantité des alcools (ii)+(iii) étant supérieure à 80 % par poids.

2. La composition selon la revendication 1 contenant
a. 0.1 - 10% par poids des nanoparticules;
b. une composition de solvant homogène consistant de
(i) 0.1 - 18 % par poids eau
(ii) 30 - 98 % par poids alcool à bas point d'ébullition
(iii) 1 - 50 % par poids alcool à haut point d'ébullition.

3. La composition selon l'une des revendications précédentes,
a. étant libre de tensioactifs ou des agents dispersants et/ou
b. ayant un contenu résiduel de carbone organique inférieur à 2.5 % par poids (après séchage pendant 1h à 250°C).

4. La composition selon l'une des revendications précédentes, lesdites nanoparticules
a. consistant d'oxyde de tungstène ayant la composition chimique WO₃ ou
b. consistant d'oxyde de tungstène dopé, 1-40 % par poids (basé sur WO₃) dudit WO₃ étant remplacé par un ou plusieurs métaux de transition.

5. La composition selon l'une des revendications précédentes, lesdites nanoparticules ayant
a. une largeur moyenne des particules primaires comprise entre 2 - 60 nm et/ou
b. une largeur hydrodynamique D₉₀ dans la suspension inférieure à 100 nm.

6. La composition selon l'une des revendications précédentes, lesdites nanoparticules étant synthétisées par un procédé en phase gazeuse.

7. La composition selon l'une des revendications précédentes, ledit alcool à haut point d'ébullition ayant
a. un point d'ébullition inférieur à 200°C et/ou
b. une formule 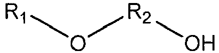 R1 et R2 représentant une chaîne alkyle linéaire ou ramifiée ayant 1 à 6 atomes de carbone chacune et le numéro totale des atomes de carbone étant entre 3 et 7.

8. Un procédé de fabrication d'un mince film, comprenant les étapes
a. d'appliquer une composition selon l'une des revendications précédentes sur un substrat ou un substrat revêtu et
b. d'enlever le solvant de ladite composition.

9. Le procédé selon la revendication 8,
a. la composition de l'étape (a) étant appliquée par un revêtement rouleau à rouleau, un revêtement sheet-to-sheet, un revêtement par centrifugation ou doctor-blading et/ou
b. le solvant de l'étape (b) étant enlevé à une température élevée.

10. Le procédé selon la revendication 8 ou 9, ledit film ayant
a. une épaisseur comprise entre 5 - 100 nm, et/ou
b. une rugosité de surface moyenne inférieure à 100 nm.

11. Le procédé selon l'une des revendications 8 - 10, ledit substrat étant un substrat de polymère, préférablement un substrat de polymère avec une énergie libre de surface inférieure à 40 mJ/m2.

12. Un mince film obtenu par un procédé selon la revendication 11.

13. Un élément électrique, comprenant un mince film obtenu par le procédé selon la revendication 11.

14. Un dispositif comprenant un ou plusieurs éléments électriques selon la revendication 13, préférablement sélectionné(s) du groupe des électroniques organiques, particulièrement une cellule solaire organique (OPV), une diode électroluminescente organique (OLED) ou un photo-détecteur organique.

15. Un procédé de fabrication d'une composition selon l'une des revendications 1 - 7, comprenant les étapes de
a. prévoir une composition de solvant homogène
b. prévoir des nanoparticules
c. combiner lesdites nanoparticules avec ladite composition de solvant homogène afin d'obtenir une suspension.

16. Utilisation d'une suspension d'une composition selon l'une des revendications 1 - 7 pour fabriquer un mince film
a. utilisable comme couche de transport de trous dans des cellules solaires organiques, dans des diodes électroluminescentes organiques ou dans des photo-détecteurs organiques;
b. dans des applications photochromiques; et/ou
c. comme catalyseur.
